# EUROPÄISCHE PATENTSCHRIFT

(11) **EP 2 842 900 B1**
(45) Veröffentlichungstag und Bekanntmachung des Hinweises auf die Patenterteilung: **09.03.2016**
(21) Anmeldenummer: 13004257.5
(22) Anmeldetag: 29.08.2013
(51) Int. Cl.: B66B 1/34

(54) **Verbindungsvorrichtung für Messbänder in Aufzugvorrichtungen**
Connecting device for measuring tapes in elevator devices
Dispositif de liaison pour rubans de mesure dans des dispositifs élévateurs

(43) Veröffentlichungstag der Anmeldung: 04.03.2015
(73) Patentinhaber: Cedes AG, 7302 Landquart (CH)
(72) Erfinder: De Coi, Beat, 7320 Sargans (CH); Leutenegger, Dr. Tobias, 7000 Chur (CH); Giger, Jan, 7233 Jenaz (CH); Thöny, Christian E., 6315 Oberägeri (CH)
(74) Vertreter: Otten, Roth, Dobler & Partner mbB Patentanwälte

(56) Entgegenhaltungen:
- WO-A1-03/066496
- FR-A1- 2 523 105

## Beschreibung

Die Erfindung betrifft eine Verbindungsvorrichtung zur Verbindung einer Ubertragungsvorrichtung im Zusammenhang mit einem Messband in einem Aufzug, ein Peripheriegerät nach dem Oberbegriff des Anspruchs 7, sowie eine Aufzugvorrichtung gemäß dem Oberbegriff des Anspruchs 9.

Gemäß dem Stand der Technik wurden bislang Kabelführungen in zum Beispiel in Kabelschächten durch den Aufzugsschacht hindurchgeführt.

WO 03/066496 A1 offenbart eine Verbindungsvorrichtung gemäß dem Oberbegriff des Anspruchs 1.

Aufgabe der Erfindung ist es, im Zusammenhang mit Messbändern, die eine integrierte Leitungsführung ermöglichen, einen möglichst flexiblen Zugriff auf die elektrischen Leitungen des Messbandes herstellen zu können.

Diese Aufgabe wird, ausgehend von einer Verbindungsvorrichtung, einem Peripheriegerät sowie einer Aufzugsvorrichtung der eingangs genannten Art, durch die Merkmale des Anspruchs 1 sowie die kennzeichnenden Merkmale der Ansprüche 7 und 9 gelöst.

Durch die abhängigen Ansprüche genannten Maßnahmen sind vorteilhafte Ausführungen und Weiterbildungen der Erfindung möglich.

Dementsprechend ist die erfindungsgemäße Verbindungsvorrichtung zur Verbindung einer Übertragungsvorrichtung zur Übertragung von Informationen als Führungsklammer zur Führung und/oder Lagerung des Messbandes ausgebildet, sodass sie das Messband wenigstens teilweise umgibt und wobei die Führungsklammer wenigstens eine Aussparung zum Auslesen der Markierungseinheit aufweist. Die erfindungsgemäße Verbindungsvorrichtung ist also im Zusammenhang mit einem Messband zu sehen, welches die Besonderheit aufweist, mit einer Obertragungsvorrichtung versehen zu sein. Gleichzeitig dient das Messband zur Bestimmung der Position einer Fahrkabine in einem Aufzugsschacht. Hinsichtlich seiner Länge ist das Messband so ausgebildet, dass es sich wenigstens über zwei Stockwerke erstreckt, wobei das Messband eine Markierungseinheit mit wenigstens zwei Markierungen zur Markierung einer Position im Aufzugschacht umfasst. Die übertragungsvorrichtung, die in das Messband integriert ist, umfasst wenigstens eine Kommunikationsleitung zur Übermittlung eines elektrischen oder optischen Signals, insbesondere einer Information. Die Kommunikationsleitung verläuft entlang der Länge des Messbandes. An Stelle von oder zusätzlich zu Kommunikationsleitungen können auch Versorgungsleitungen vorgesehen sein, die zum Beispiel der Stromversorgung elektrischer Geräte dienen.

Zudem umfasst ein derartiges Messband ein Trägerband, in welches die Leitungen zum Beispiel integriert sind. Denkbar ist auch eine Ausbildung, bei dem das Messband als Verbundmaterial ausgebildet, das zur Stabilisierung zum Beispiel ein Trägerband, insbesondere in seiner Mitte umfasst.

Damit auf einzelnen Stockwerken oder an sonstiger, im Grunde beliebiger Stelle im Aufzugschacht ein Zugang zu den Leitungen ermöglicht wird, bei dem Informationen entnommen oder eingespeist bzw. eine Spannung abgegriffen werden kann, wird in vorteilhafter Weise die erfindungsgemäße Verbindungsvorrichtung eingesetzt. Sie zeichnet sich durch ein hohes Maß an Flexibilität aus, da praktisch überall auf die Leitungen des Messbands zugegriffen werden kann.

Die erfindungsgemäße Verbindungsvorrichtung wenigstens einen Verbindungskontakt zur Verbindung mit einer der Kommunikationsleitungen und/oder Versorgungsleitungen auf, wobei der wenigstens eine Verbindungskontakt beweglich in der Verbindungsvorrichtung gelagert ist.

Gerade bei neu gebauten Häusern tritt regelmäßig der Effekt auf, dass sich der Bau mit der Zeit "setzt", das heißt, dass die Gebäude aufgrund von Materialbelastungen, Veränderungen in der Bausubstanz usw. mit der Zeit etwas gestaucht werden. Um diesem bauphysikalischen Effekt beim Bau eines Aufzugs in einem Gebäude von Anfang an Rechnung tragen zu können, können zum Beispiel Positionsmarkierungen am Aufzuggerüst, an dem die Fahrkabine fahrbar gelagert ist, angebracht werden, da das Fahrgerüst von dem Prozess des "Sich-Setzens" des Gebäudes zumindest nicht unmittelbar betroffen,ist; die Markierungen ändern in diesem Fall ihre Position relativ zum Aufzug nicht. Eine solche Vorgehensweise kann jedoch die Problematik mit sich bringen, dass die Markierungen am Fahrgerüst nicht mehr mit den tatsächlichen Positionen der einzelnen Stockwerke im Gebäude übereinstimmen, sobald sich das Gebäude gesetzt hat. Wird das Messband hingegen nicht am Fahrgerüst, sondern im Aufzugschacht befestigt, und zwar gleichzeitig in der Weise, dass es durchgängig oder zumindest an mehreren Stellen mit dem Aufzugschacht fest verbunden ist, so kann sich das Messband wölben, verformen oder zumindest unter Spannung stehen, wenn sich das Gebäude setzt.

Aus diesem Grund ist das Messband beweglich gelagert und in der Regel nur an der Decke des Aufzugsschachts befestigt. Feste Kontakte bilden grundsätzlich jedoch eine weitere feste Verbindung zum Messband. Da in vorteilhafter Weise die Kontakte jedoch selbst beweglich gelagert sind, können diese der Setzbewegung des Gebäudes in vorteilhafter Weise folgen, ohne dass das Messband Spannungen unterworfen ist oder sich wölben muss.

Bei einer Ausführungsform der Erfindung kann die Verbindungsvorrichtung einen drahtgebundenen elektrischen Kontakt herstellen. Sie kann beispielsweise einen Schneidkontakt zum schneidenden Kontaktieren einer Leitung umfassen. Ein solcher Schneidkontakt durchschneidet bzw. verletzt zunächst in der Regel die Isolierung der Kontaktleitung und stellt anschließend eine elektrische Verbindung zum elektrisch leitenden Draht der Leitung her. Denkbar ist es auch, eine Crimpvorrichtung einzusetzen, bei der nicht nur die Isolierung verletzt wird, sondern auch ein Fügeprozess zum Kontaktieren angewandt wird, bei dem durch plastische Verformung der Kontakt mit dem Draht herstellbar ist. Beide Verbindungsarten sind insbesondere vorteilhaft, weil die Isolierung nur an der entsprechenden Kontaktstelle geöffnet wird. Bei einer Crimpvorrichtung wird zwar zudem der Draht selbst verletzt, allerdings wird dafür eine mechanisch sehr stabile und zuverlässige Verbindung herstellbar ist, weil durch den Fügeprozess gute elektrische Verbindung gewährleistet werden kann.

Denkbar ist es auch, einen federgespannten Kontaktpin bei einer Ausführungsform der Erfindung einzusetzen. Die Federspannung ermöglicht eine ständige mechanische Verbindung, wobei diese Verbindungsart insbesondere dann genutzt werden kann, wenn der zu kontaktierende Leiter nicht mit einer Isolierschicht umgeben ist, sondern beispielsweise als Leiterbahn ausgebildet ist, bei der ein einfacher mechanischer Kontakt (ohne plastische Verformung) ausreicht. Insbesondere handelt es sich in vorteilhafterweise um eine zerstörungsfreie Kontaktierung. Sie ist auch jederzeit durch die Bedienung der Feder reversibel, sodass der Kontaktpin an eine andere Stelle versetzt werden kann.

Auch drahtlose Verbindungen werden gemäß der Erfindung möglich, beispielsweise als induktive oder kapazitive Verbindungen. Eine induktive Verbindung setzt voraus, dass die zu kontaktierende Leitung an der entsprechenden Stelle nicht geschirmt ist. Eine kapazitive Verbindung kann ebenfalls hergestellt werden. Beispielsweise kann eine kapazitive Kopplung durch eine Art Schelle oder Mantel, welcher die zu kontaktierende Leitung zumindest teilweise umgibt, erreicht werden. Bei einer kapazitiven Kopplung ist es notwendig, dass zwischen den beiden Kondensatorplatten, also dementsprechend der Schelle oder dem Mantel und dem Draht andererseits ein Isolator beziehungsweise ein Nichtleiter / Dielektrikum vorgesehen ist. Diese Möglichkeiten stellen ebenfalls Verbindungen dar, bei denen die Leitungen nicht beschädigt werden.

Denkbar ist es aber auch, einen Verbindungsstecker vorzusehen beziehungsweise männliche Steckverbindungen vorzusehen, was insbesondere dann vorteilhaft ist, wenn in regelmäßigen Abständen am Messband Verbindungsdosen vorgesehen sind. Je nachdem, ob eine Leitung spannungsführend ist oder nicht, kann entsprechend zwischen einer männlichen oder weiblichen Steckverbindung gewechselt werden. Des Weiteren kann eine Verbindungstestvorrichtung zum Testen der Verbindung zu wenigstens einer der Leitungen an einer bestimmten Stelle vorgesehen sein, die also beispielsweise den Durchgang prüft oder optische Signale überprüft, die hervorgerufen werden, wenn eine Steckverbindung korrekt eingesteckt wurde. Dadurch kann eine schnelle Wartung und Instandhaltung sowie ein schnelles Testen in vorteilhafter Weise erfolgen.

Die erfindungsgemäße Verbindungsvorrichtung bzw. eine Ausführungsform der Erfindung kann vorteilhafterweise bei einer Positionsbestimmungsvorrichtung, bei welcher die Position einer Fahrkabine mit Hilfe des in Rede stehenden Messbands bestimmt wird, eingesetzt werden. Erfindungsgemäß kann sie aber auch bei einer Sicherungsvorrichtung, die eine Übertragung von sicherheitsrelevanten Daten über die Kontaktleitungen der übertragungsvorrichtung des Messbandes nutzt, eingesetzt werden. Die Sicherungsvorrichtung dient beispielsweise dazu, den Antrieb der Fahrkabine zu beeinflussen, wenn Störungen auftreten, indem beispielsweise Schachttüren oder Kabinentüren blockiert werden. All dies kann über die entsprechenden Datenleitungen an die Sicherungsvorrichtung weitergeleitet werden, sodass diese auch abgreifbar in jedem Stockwerk über die Leitung des Messbandes zur Verfügung stehen.

Eine derartige Sicherungsvorrichtung kann insbesondere auch eine Testvorrichtung zum Testen des Messbandes auf Ausdehnungen des Bandes bzw. auf Risse oder Brüche hin verwenden. Der Test kann mittels einer Laufzeitmessung durchgeführt werden. Ferner ist es möglich, Kapazitätsmessungen der Leitungen oder auch eine einfache Durchgangsprüfung durchzuführen. Hierdurch wird eine rasche Wartung ermöglicht. Insgesamt wird vor allem jedoch die Sicherheit einer solchen Aufzugvorrichtung erhöht.

Denkbar ist es auch, bei einer vorteilhaften Weiterbildung der Erfindung eine Verbindungstestvorrichtung zum Testen der Verbindung zu wenigstens einer der Leitungen an einer bestimmten Stelle, beispielsweise in Höhe bestimmter Stockwerke vorzusehen, sodass ebenfalls die Instandhaltungen und Wartungen schnell erfolgen kann. Beispielsweise kann es vorgesehen sein, beim Kontaktieren optischer Signale auszulösen oder eine Durchgangsprüfung an entsprechender Stelle vorzusehen. Da die Übertragungsvorrichtung auch allgemein zur Kommunikation dienen kann, kann auch eine Kommunikationsvorrichtung die entsprechende Verbindungsvorrichtung gemäß der Erfindung oder einer ihrer Ausführungsformen nutzen, wenn sie eine Informationsübertragung über das Messband vorsieht.

Allgemein können entsprechende Peripheriegeräte, Positionsbestirnmungsvorrichtungen, Sicherungsvorrichtungen oder Kommunikationsvorrichtungen, gemäß einem der Ausführungsbeispiele der Erfindung in eine erfindungsgemäßen Aufzugvorrichtung verwendet werden, wobei sämtliche Vorteile im Zusammenhang mit der Verbindungsvorrichtung gemäß der Erfindung zur Verfügung stehen.

### Ausführungsbeispiele:

Ausführungsbeispiele der Erfindung sind in den Zeichnungen dargestellt. Abgebildet sind sowohl das Messband als auch entsprechende Verbindungsvorrichtungen. Diese werden unter Angabe weiterer Einzelheiten und Vorteile näher erläutert.

Im Einzelnen zeigen:
- Fig. 1: eine schematische Darstellung eines Aufzugsschachts mit Messband,
- Fig. 2: ein Messband mit Leitungen,
- Fig. 3: ein Querschnitt eines Messbands,
- Fig. 4: ein Messband mit Erdungsanschlüssen und Entstörkondensator,
- Fig. 5: ein Messband mit Erdungsanschlüssen,
- Fig. 6: eine parallele Leitungsführung im Messband,
- Fig. 7: eine verflochtene Leitungsführung,
- Fig. 8a: mäandrierende Leiterbahnen,
- Fig. 8b: mäandrierende Leiterbahnen (Draufsicht),
- Fig. 9: eine Verbindungsvorrichtung mit Unterbrechuhgskontakt,
- Fig. 10: eine Crimpvorrichtung,
- Fig. 11: federgespannte Kontaktpins,
- Fig. 12: eine kapazitive Verbindung,
- Fig. 13: eine einschlaufige induktive Verbindung,
- Fig. 14: eine mehrschlaufige induktive Verbindung,
- Fig. 15: eine Steckerkontaktierung am Messband,
- Fig. 16: ein Sicherheitssystem mit Bus,
- Fig. 17: ein Positionssensor an der Fahrkabine beim Auslesen eines Messbands / Codebands,
- Fig. 18: ein optischer Schalter,
- Fig. 19: eine Verbindungsvorrichtung mit beweglicher Kontaktierung, sowie
- Fig. 20: eine Verbindungsvorrichtung mit beweglicher Kontaktierung (Draufsicht).

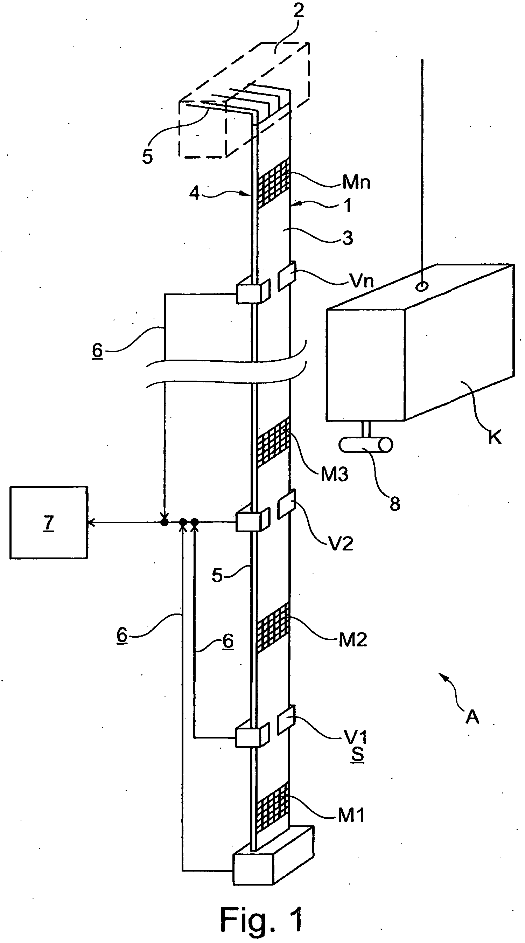

Figur 1 zeigt eine Aufzugsvorrichtung A mit einem Aufzugsschacht S, in dem eine Fahrkabine K verfahrbar gelagert ist. Entlang des Aufzugsschachts ist ein Messband 1 hängend angeordnet. Das Messband 1 ist lediglich an seinem oberen Ende über eine Montagevorrichtung 2 befestigt. Auf der vorderen, der Kabine K zugewandten Seite 3 befindet sich eine Markierungseinheit mit mehreren Markierungen M1, M2, M3, Mn. Auf dem vorderen Bereich 3 des Messbandes 1 befindet sich eine Reflexionsschicht, die sich über das gesamte Messband 1 der Länge nach erstreckt. Die Markierungen M1, M2, M3, Mn sind als aufgedruckte 2D-Codes ausgebildet.

Die Markierungen M1, M2, M3, Mn sind verschlüsselt, sodass eine Positionsbestimmungsvorrichtung den speziellen Schlüssel zur Entschlüsselung / Dekodierung dieser sensorisch erfassten Markierungen benötigt, um die codierten Daten gewinnen zu können. Im vorliegenden Fall ist über die Markierung M1, M2, M3, Mn die Position der entsprechenden Aufzugkabine K im Schacht S markiert. Befindet sich die Kabine K an einer entsprechenden Stelle und liest deren Sensor beispielsweise die Markierung M2 aus, so entspricht die kodierte Positionsangabe auf der Markierung M2 der aktuellen Position der Aufzugkabine K.

Auf der Rückseite, das heißt der der Kabine K abgewandten Seite 4 des Messbands 1 befinden sich Kommunikationsleitungen 5, über welche Informationen übermittelt werden können. Diese Kommunikationsleitungen 5 verlaufen entlang der gesamten Länge des Messbands 1 von oben nach unten. In Höhe der einzelnen Stockwerke sind zudem Verbindungsvorrichtungen V1, V2, Vn angeordnet, d.h. auf jedem Stockwerk befindet sich eine dieser Verbindungsvorrichtungen V1, V2, Vn. Die Markierungen M1, M2, M3, Mn müssen nicht voneinander beabstandet angeordnet sein, sondern es ist auch denkbar, jede Markierung unmittelbar an die vorangegangene anzuschließen. Es kann vielmehr vorteilhaft sein, die Markierungen über die Länge des Schachts S bzw. über die Länge des Messbands 1 hinweg "kontinuierlich" anzuordnen, sodass an jeder Stelle die aktuelle Position ausgelesen werden kann.

Denkbar ist darüber hinaus, dass bestimmte Positionen im Schacht gesondert markiert bzw. kodiert sind. Beispielsweise existieren so genannte "Sicherheitszonen" um jeden Stockwerkszugang im Schacht bzw. um jede Schachtöffnung herum. Muss der Aufzug innerhalb einer dieser Sicherheitszonen anhalten, beispielsweise in einem Notfall, so können die Türen geöffnet werden, obschon sich die Kabine nicht in der vorgeschrieben Ausstiegsposition eines Stockwerks (z.B. mit dem Kabinenboden bündig an der Schachtöffnung) befindet. In dieser Notsituation ist aber ein Ausstieg in der Sicherheitszone möglich und somit unbedingt von der Sicherheitsvorrichtung des Aufzugs zuzulassen, indem z.B. die Türen der Kabine entriegelt werden können.

Die Verbindungselemente v1, V2, Vn besitzen Kontaktierungen zu den Kommunikationsleitungen 5. Über diese Kontaktierungen werden Leitungen 6 an eine Elektronikeinheit 7 weitergeführt. Bei der Elektronikeinheit 7 handelt es sich vorliegend um eine Sicherungsvorrichtung, die beispielsweise überwacht, ob die Aufzugtüren, zum Beispiel die Schachttüren, die am Aufzugschacht S angebracht sind oder die Kabinentüren an der Kabine K während der Fahrt ordnungsgemäß geschlossen oder beim Ausstieg geöffnet sind oder ob eine Störung beispielsweise durch Blockade einer Tür vorliegt.

An der Kabine K ist ein optischer Sensor 8 angeordnet, welcher der Auslesung der Marierungen M1, M2, M3, Mn dient und die gewonnenen Daten an eine Positionsbestimmungsvorrichtung weiterleitet.

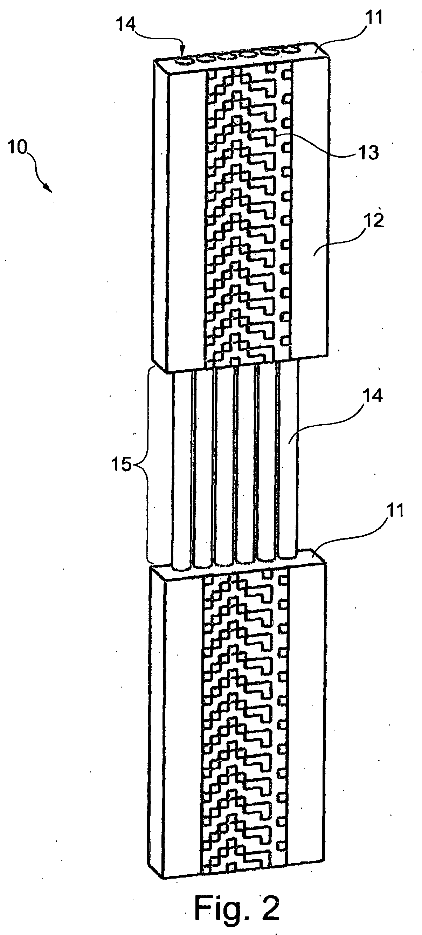

Figur 2 zeigt eine schematische Darstellung eines Messbands 10 mit einem Trägerband 11. Auf dem Messband 10 sind die beiden Seitenränder an der Vorderseite frei gelassen, während mittig ein Markierungsstreifen 13 angebracht ist, der eine Reflexionsschicht mit darauf aufgedrucktem 2D-Code als Markierung umfasst. Das Trägerband 11 selbst ist als Stahlband ausgebildet. Im Trägerband 11 sind Kommunikationsleitungen 14 eingebettet, die aus elektrisch leitenden, gegenüber dem Stahlband jedoch isolierten Drähten besteht. Diese verlaufen bei der Ausführungsform gemäß Figur 2 parallel. Zur übersichtlichen Darstellung sind im Bereich 15 die Leitungen 14 ohne Trägerband eingezeichnet. Der Seitenbereich 12 ist deshalb.freigelassen, damit er dort von der Lagerung teilweise umgriffen werden kann, ohne dass der Markierungsstreifen 13 verdeckt ist. Um die Markierungen bzw. den 2D-Code 13 auslesen zu können, muss ein entsprechender Codierungsschlüssel in der Positionsbestimmungsvorrichtung hinterlegt sein.

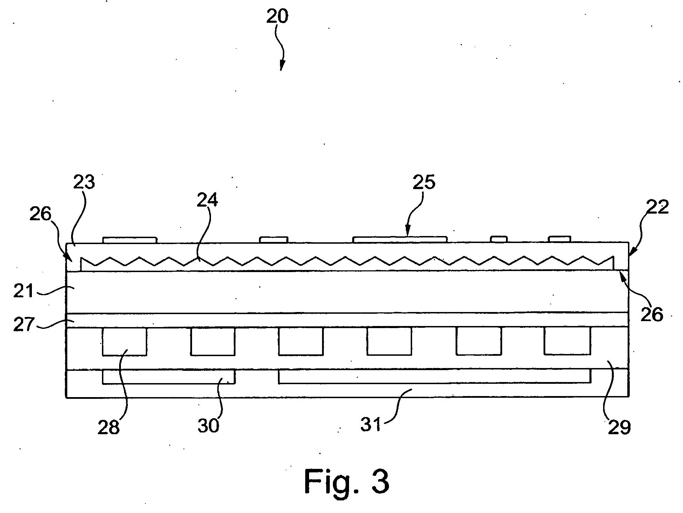

Figur 3 zeigt eine detaillierte Darstellung eines Aufbaus eines derartigen Messbands 20. Als Grundbestandteil besitzt dieses Band 20 ein Trägerband 21, welches aus Stahl ausgebildet ist. An der in Figur 3 oberen Seite des Trägerbands 21 befindet sich die Markierung 22, die wiederum zunächst eine durchsichtige Kunststoffschicht 23 an der Oberfläche besitzt. Zwischen dem überwiegenden Teil der Kunststoffschicht 23 und dem Trägerband 21 ist eine Art Luftpolster 24 angeordnet. Zum Luftpolster 24 hin ist die Kunststoffschicht 23, die in der Regel aus Polyester oder Polycarbonat besteht, gezackt ausgebildet. Auf der äußeren Oberfläche der Kunststoffschicht 23 wiederum befinden sich Code-Aufdrucke 25 zur Codierung von Positionsangaben. Im Randbereich 26 ist die Kunststoffschicht 23 am Trägerband 21 befestigt. Das Luftpolster 24 ist notwendig, damit Licht, das beispielsweise von einem optischen Sensor der Aufzugskabine durch den transparenten Kunststoff 23 hindurch gelangt, an der zackenartigen Grenzfläche zwischen Kunststoffschicht 23 und Luftpolster 24 reflektiert und zurückgeworfen wird. Fällt das Licht hingegen auf einen Codedruck 25, wird es weitgehend absorbiert. Auf diese Weise wird der Code ausgelesen und erfasst.

Auf der anderen Seite des Trägers ist zunächst eine Isolierschicht 27 angeordnet. Unmittelbar an dieser Isolierschicht 27 befinden sich Kupfer- oder Aluminiumleitungen 28. Diese Leitungen 28 wiederum sind von einem Isolator 29 abgedeckt. Die Leitung 28 ist somit zwischen Isolatoren 27, 29 eingebettet. Auf dem Isolator 29 wiederum befinden sich aufgedruckte Leiterbahnen 30, die wiederum von einer Isolatorschicht 31 abgedeckt wird. Das Messband umfasst, also auf seiner Markierungsseite ein Reflexionsband, wobei zur Markierung lediglich einige Bereiche, die eine Codierung darstellen, durch schwarze Bereiche (Bedruckungen) abgedeckt sind. Auf der Markierungsseite des Messbands kann es vorteilhaft sein, lediglich, einen mittleren Streifen entlang der Länge des Messbands mit den Markierungen zu versehen und die Seitenbereiche zumindest teilweise freizulassen. Diese Maßnahme ist deshalb vorteilhaft, weil das Messband meistens nicht starr in regelmäßigen Abständen befestigt ist, sondern im oberen Bereich des Schachts aufgehängt wird und ansonsten beweglich gelagert wird. Diese Lagerung kann vorteilhafterweise durch eine teilweise Umklammerung erfolgen, sodass das Codetape an den Rändern umgriffen wird, die Umklammerung jedoch das Messband nicht vollständig umgibt sondern einen offenen Spalt lässt. Aus Symmetriegründen kann dieser somit in der Mitte des Messbands liegen.

Gerade dann, wenn neue Gebäude gebaut werden, macht sich der Effekt bemerkbar, dass diese sich mit der Zeit "setzen", das heißt, ihre Höhe verringert sich geringfügig mit der Zeit. Wäre das Messband in regelmäßigen Abständen fixiert, so würde es sich wellenartig abheben, wenn das Gebäude sich in seiner Höhe verkürzt bzw. gestaucht wird. Ist das Messband jedoch beweglich gelagert, so kann es sich in den Lagerungshalterungen bewegen, und die Halterung muss nicht geöffnet werden, und das Messband muss auch nicht neu einjustiert werden. Die vorgegebenen Randbereiche können etwa für einzelne Markierungen, wie beispielsweise zur Markierung von Sicherheitszonen, um jeden Etagenausstieg herum, genutzt werden, zumal in diesem Fall auch keine durchgehende, ununterbrochen Markierung notwendig ist, die von einer Lagerung verdeckt werden könnte.

Die Reflexion kann durch Rückreflektoren im Reflexionsband erreicht werden, beispielsweise auch durch kleine spiegelnde Kugel oder durch die Anordnung von Prismen. Auch die Anbringung gekrümmter Spiegel ist grundsätzlich möglich.

Das Trägermaterial 21, das vorwiegend aus Stahl ausgebildet ist, garantiert einerseits eine hohe mechanische Stabilität. Zudem kann es auch glasfaserverstärkt sein oder kohlefaserverstärkt. Diese Verstärkung ist insbesondere vorteilhaft, weil das sehr lange Messband auch ein nicht unerhebliches Gewicht aufweisen und sich deshalb mit der Zeit ebenfalls noch einmal strecken kann. Diese Ausdehnung des Messbands kann dadurch reduziert werden. Insgesamt muss das Messband jedoch ohnehin einigen Belastungen im Aufzugschacht S standhalten können, nämlich zum einen den dort herrschenden Temperaturen und Temperaturunterschieden, der Feuchtigkeit, dem Staub, Korrosion, insbesondere durch Feuchtigkeit, mechanischer Abrieb sowie Wind. Die einzelnen Schichten, Bedruckungen usw. können auf verschiedenste Art und Weise miteinander befestigt werden, beispielsweise durch Laminieren, Kleben, Löten, durch Verschweißen oder durch sonstige Methoden zur Herstellung einer Verbindung. Insbesondere können Schichten oder Markierungen auch aufgedruckt werden.

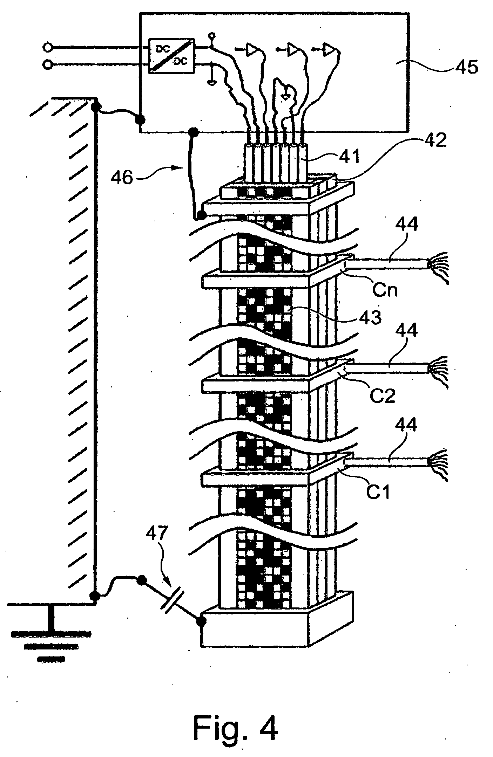

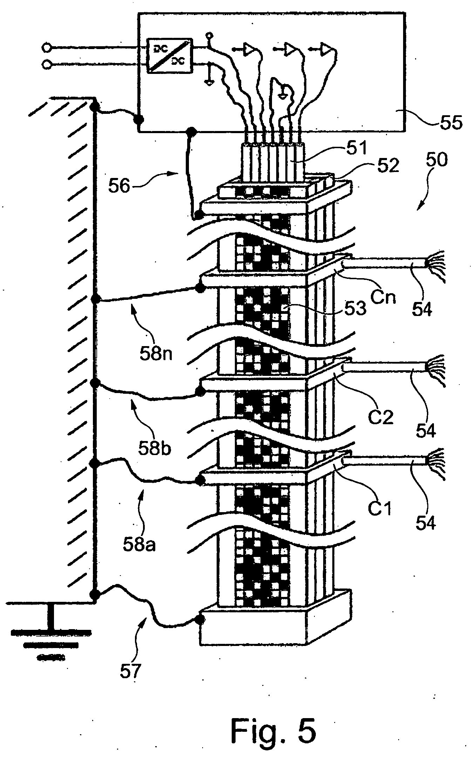

Figur 4 und Figur 5 zeigen Möglichkeiten, eine Erdung herzustellen bzw. Abschirmungen zu bewirken. Figur 4 zeigt eine schematische Darstellung eines Messbands 40 mit Kommunikationsleitungen 41. Im Außenbereich befindet sich ein Metallkäfig 42, der das Messband mit seinen Leitungen 41 umschließt. Zudem ist außen ein Markierungsstreifen 43 vorgesehen. In Höhe jeder einzelnen Etage befindet sich ein Verbindungsclip, C1, C2, Cn, der gleichzeitig Kontaktierungen zu den Leitungen 41 bereitstellt, sodass entsprechende Verbindungsleitungen 44 jeweils von den Clips C1, C2, Cn herausgeführt werden können. Die Kommunikationsleitungen 41 können parallel angeordnet sein oder miteinander jeweils paarweise verflochten werden, um eine Abschirmung zu erreichen. Bei parallel angeordneten Leitungen ist ein Erdungskabel jeweils zwischen den einzelnen Kommunikationsleitungen angeordnet. Die Kommunikationsleitungen wiederum sind galvanisch von der Elektronik getrennt, mit der sie über die Leitung 44 verbunden sind. Auch im oberen Bereich des Aufzugsschachts sind die Kommunikationsleitungen 41 über eine galvanische Trennung 45 mit weiterer Elektronik verbunden. Am oberen Ende des Messbands ist der Metallkäfig über eine Erdungsleitung 46 geerdet. Im unteren Bereich ist der Metallkäfig über einen Kondensator 47 mit der Erde verbunden. Der Kondensator 47 wird auch als Entstörkondensator bezeichnet. Dieser Kondensator 47 stellt eine Art Bypass dar, um hochfrequente Schwingungen abzuleiten, da ohne Entstörkondensator das Messband 40 wie eine Antenne wirken könnte.

Figur 5 zeigt ein ähnliches Messband 50 mit Kommunikationsleitungen 51, einen Metallkäfig 52, einzelnen Clips C1, C2 und Cn zur Kontaktierung der Leitungen 51. Im äußeren Bereich ist ferner eine durchgehende Markierung 53 entlang der Länge des Messbands 50 angebracht. über die Clips C1, C2, Cn werden die kontaktierten Leitungen 51 über Kabel 54 nach außen geführt und mit weiterer Elektronik verbunden. Die Leitungen 51 können ebenfalls parallel mit Erdungskabeln zur Abschirmung dazwischen angeordnet werden oder aber paarweise verflochten werden, sodass kein interner "Crosa-Talk" entsteht, das heißt, die Leitungen sich bei der Signalleitung nicht gegenseitig beeinflussen. Im oberen Bereich sind die Kommunikationsleitungen 51 wiederum über eine galvanische Trennung 55 mit weiterer Elektronik verbunden bzw. mit einer Spannungsquelle, sofern auch Leitungen zur Stromversorgung innerhalb der Leitungen 51 vorgesehen sind.

Im vorliegenden Fall nach Figur 5 ist nicht nur am oberen Ende des Messbands 50 eine Erdung des äußeren Metallkäfigs 52 über eine Erdungsverbindung 56 vorgesehen, sondern unter anderem auch im Endbereich, nämlich über die Leitung 57. Entstörkondensatoren sind nicht vorgesehen. Damit jedoch keine Ausgleichsströme fließen, weil die Erdung an unterschiedlichen Stellen des Messbandes angebracht sind, die wiederum weit auseinander liegen, ist eine Erdung an jedem Clip C1, C2, Cn in Höhe jedes Stockwerks vorgesehen, und zwar über die entsprechenden Leitungen 58a, 58b, 58n.

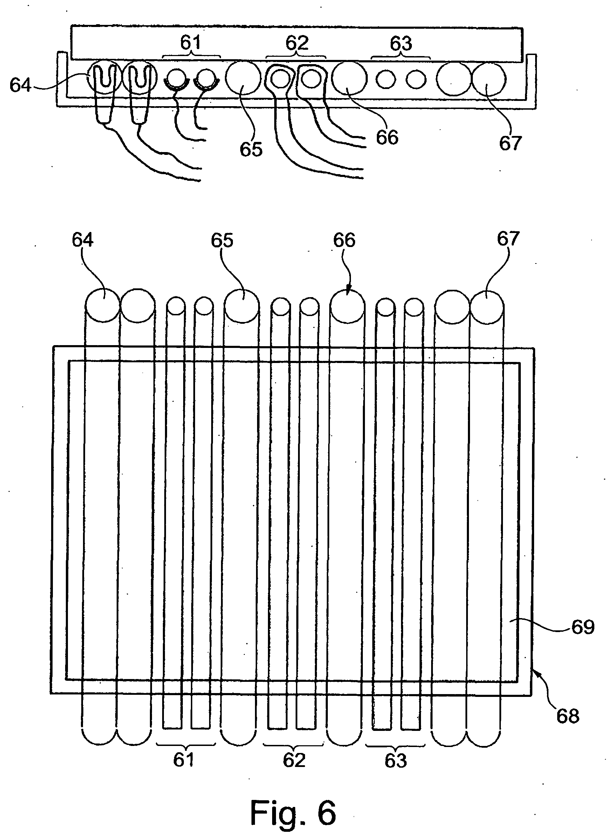

Figur 6 zeigt mehrere Kommunikationsleitungskabel bzw. Stromleitungskabel-Paare 61, 62, 63, welche entlang der länge des Messbands parallel angeordnet sind und durch Erdungskabel 64, 65, 66, 67 voneinander abgeschirmt werden. Zudem ist eine Abdeckung 68 über den einzelnen Kabeln angebracht, die ebenfalls metallisch sein kann und mit der Erde verbunden ist, um eine Abschirmung zu erreichen. An einer Stelle ist in dieser Abdeckung 68 ein Schlitz 69 angeordnet, in dessen Bereich also eine Kontaktierung bzw. ein Zugang unmittelbar möglich ist.

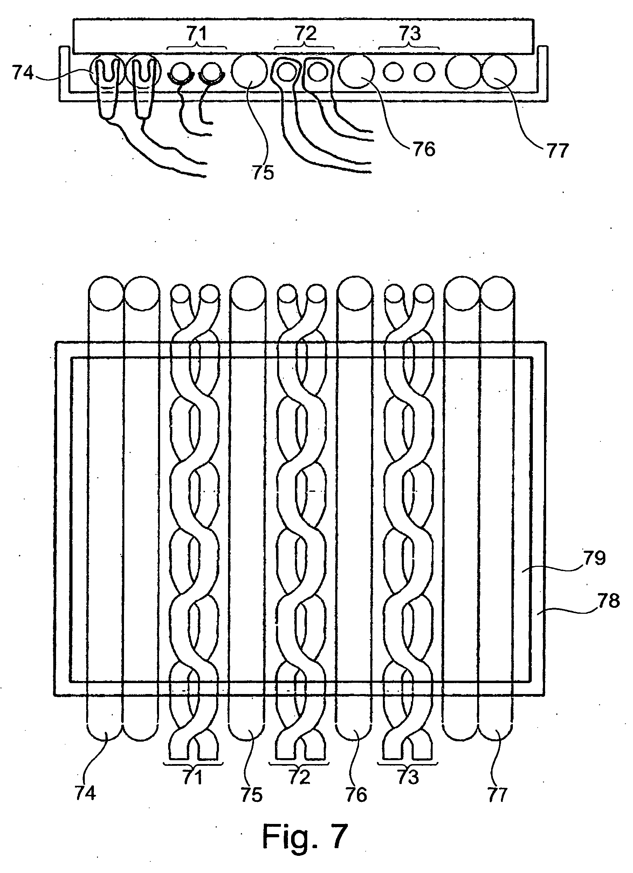

Figur 7 zeigt eine analoge Anordnung von Kabelpaaren 71, 72, 73, wobei die jeweiligen Paare 71, 72, 73 miteinander verflochten sind und so eine Abschirmung erreicht wird. Zusätzlich sind zwischen den einzelnen Paaren 71, 72, 73 Erdungskabel 74, 75, 76, 77 angeordnet. Über den Kabeln befindet sich ebenfalls eine geerdete Abdeckung 78 mit einer. Aussparung 79, über die eine Kontaktierung erfolgen kann.

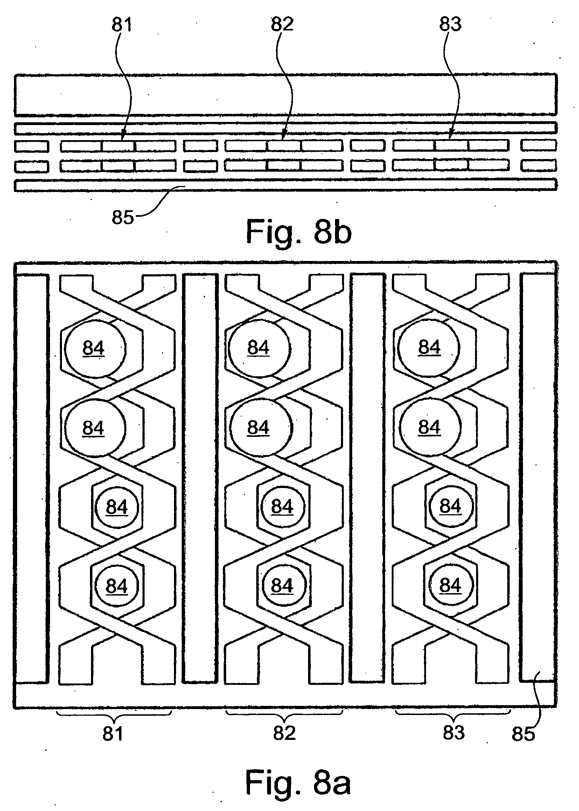

Die Figuren 8a und 8b zeigen ebenfalls Leitungspaare 81, 82, 83, die als Leiterbahnen (zum Beispiel aufgedruckt) ausgebildet sind. Analog zu einer verflochtenen Anordnung gemäß Figur 7 sind diese Leiterbahnen 81, 82, 83 mäandrierend angeordnet. Die Leiterbahnen können so gedruckt werden, dass sie mäanderartig sich jeweils kreuzen. Unterschiedliche Leiterbahnen können unmittelbar nebeneinander angeordnet werden oder in unterschiedlichen Schichten jeweils aufeinander liegen. Die Verflechtung von Leiterbahnen kann so erfolgen, dass bei drei Leiterbahnen diese ähnlich wie ein Zopf miteinander verflochten sind, sodass zwei unterschiedliche Leiterbahnen eine Art Bauch nach außen hin über der Längsrichtung darstellen und in der Mitte eine Kontaktierungsmöglichkeit 84 (zur mittleren Leiterbahn) geschaffen wird. Im äußeren Bereich können die Leiterbahnen wiederum von einem geerdeten Käfig 85 umschlossen und abgeschirmt werden. Figur 8b zeigt eine analoge Darstellung eines Querschnitts in Draufsicht auf ein entsprechendes Messband.

Grundsätzlich können die entsprechenden Leiterbahnen durch sogenannte "VIAs" kontaktiert werden.

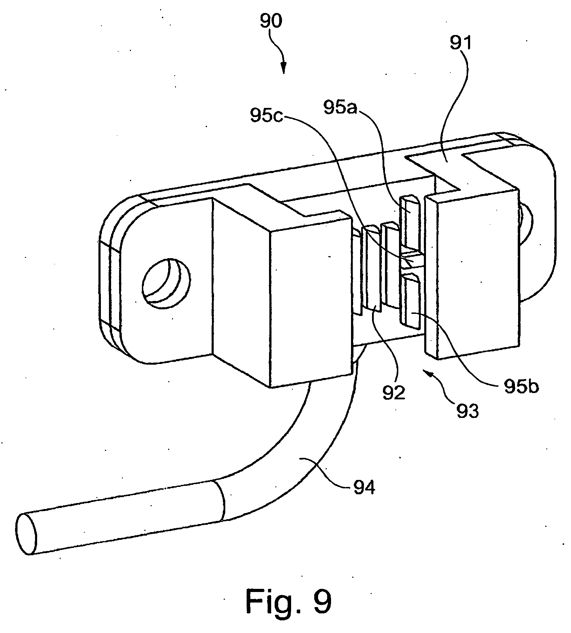

Figur 9 zeigt eine Verbindungsvorrichtung 90 mit einer an der Schachtwand anschraubbaren äußeren Klammervorrichtung 91, welche das Messband teilweise umgreifen kann sowie ferner mit Kontaktierungselektroden 92, die als Schneidkontakte ausgebildet sind. Die Klammer 91 besitzt eine Aussparung 93, welches ermöglicht, dass die Markierungen, die auf einer Seite des Messbands angebracht sind, durch einen optischen Sensor an der Kabine ausgelesen werden können. Die Kontakte 92 sind über ein Kabel 94 nach außen geführt, beispielsweise zur Elektronik einer Sicherungsvorrichtung. Die Verbindungskontakte 95a, 95b sind ebenfalls als Schneidkontakte ausgebildet. Die Schneide 95c ist ein Isolator, die elektrische Leitung des Messbandes durchtrennt. Vor und hinter der Unterbrechung erfolgt sodann eine Kontaktierung über die Schneidkontakte 95a, 95b. Diese sind an eine Sicherheitselektronik angeschlossen und überbrücken im Normalbetrieb die Unterbrechung. Nur bei einem entsprechenden Defekt erfolgt sodann tatsächlich eine Unterbrechung. Diese Unterbrechung führt zu einer Abschaltung im Sicherheitskreis, wodurch zum Beispiel der Antrieb des Aufzugs unterbrochen wird. Es handelt sich also um eine Fail-Safe-Schaltung zur Erhöhung der Sicherheit.

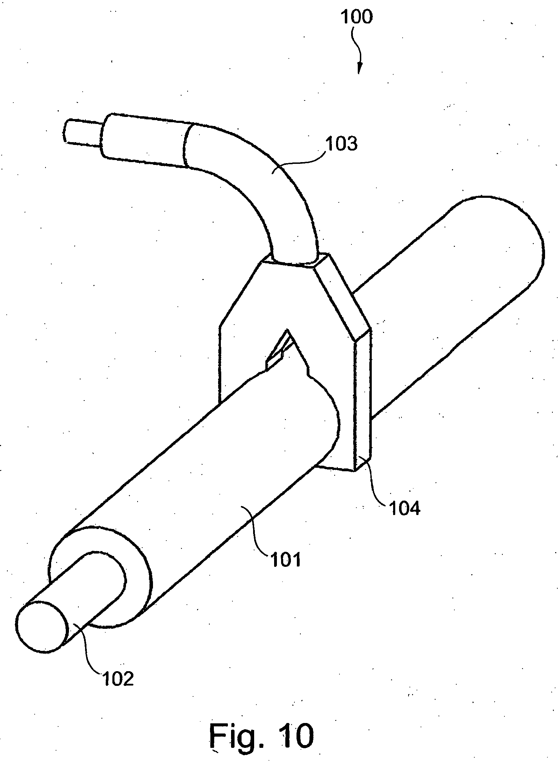

Figur 10 zeigt eine Kontaktierungsmöglichkeit. Dargestellt ist zunächst eine Kommunikationsleitung 100, die entlang eines Messbandes angeordnet ist. Diese umfasst im äußeren Bereich eine Isolierung 101 sowie einen Leiterdraht 102, welcher in der Mitte der Leitung 100 angeordnet ist. Zur Verbindung des Drahtes 102, mit einem Kabel 103 ist ein Schneidkontakt 104 am Kabel 103 angebracht, dessen Schneiden die Isolierung 101 durchtrennen können und zumindest im Randbereich auch teilweise in das Material des Drahtes 102 eindringen. Dadurch wird eine besonders stabile und zuverlässige elektrische Verbindung hergestellt.

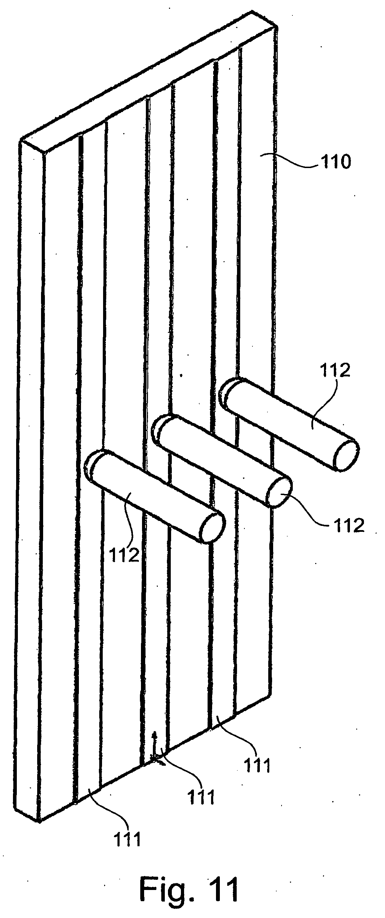

Figur 11 zeigt ein Messband 110, auf dem Leiterbahnen 111 aufgedruckt sind. Diese werden über federgespannte Kontaktpins 112 kontaktiert. Diese Pins erhalten also durch eine auf Druck gespannte Feder eine Anpresskraft, welche dafür sorgt, dass ein stabiler Kontakt zwischen Pin und Leiterbahn 111 hergestellt wird.

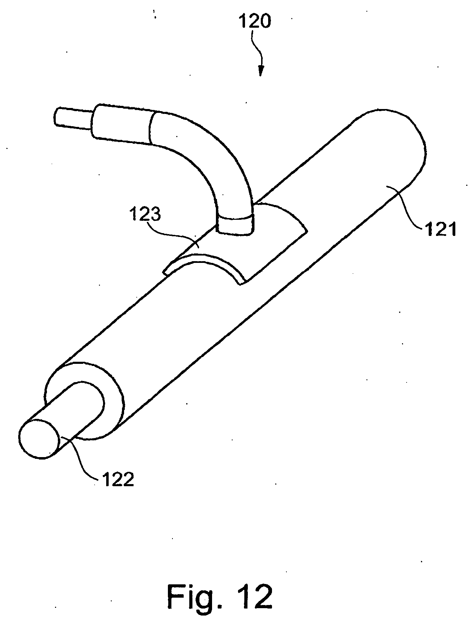

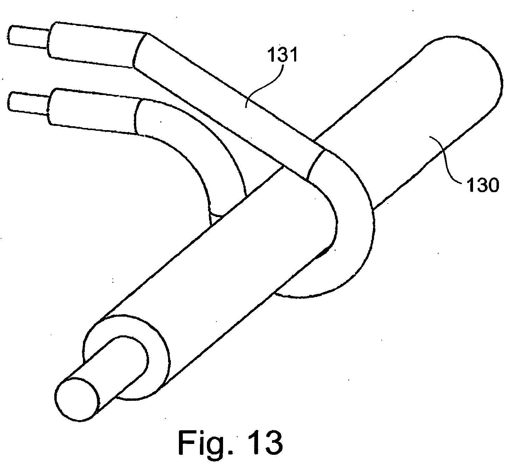

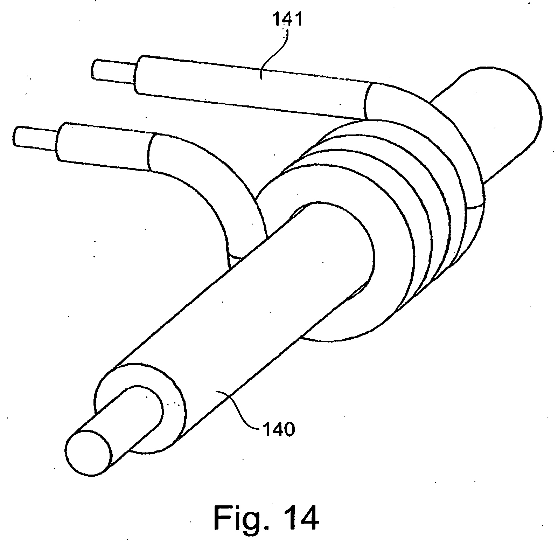

Daneben bestehen zum Beispiel Möglichkeiten, eine drahtlose Verbindung herzustellen. Figur 12 zeigt eine kapazitive Verbindung einer Leitung 120 mit einer Isolierung 121 und einem Leitungsdraht 122. Im äußeren Bereich der Isolierung 121 ist eine Art Schelle 123 vorgesehen, welche die Leitung 120 teilweise umkreist. Die Schelle 123 wirkt also wie eine Kondensatorplatte, sodass eine kapazitive Verbindung zwischen der Schelle 123 und dem Draht 122 bewirkt wird. Die Figuren 13 und 14 stellen induktive Kopplungen dar, indem jeweils die Leitung 131 um die Leitung 130 bzw. die Leitung 141 um die Leitung 140 gewickelt wird.

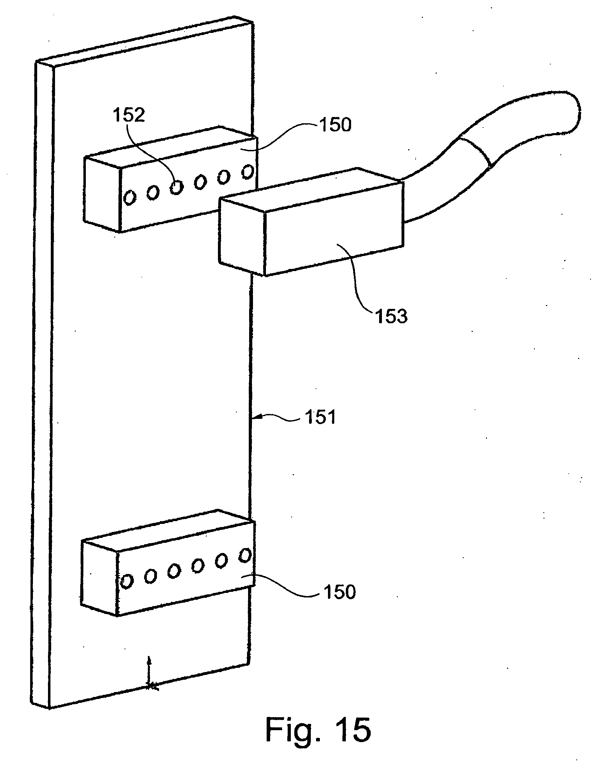

Eine besonders elegante Verbindung ist in Figur 15 dargestellt. In ähnlicher Weise sind im Erdungskäfig regelmäßig Aussparung zur Kontaktierung vorgesehen sein können, ist es auch möglich, vorgefertigte Steckdosen 150 in regelmäßigen Abständen, zum Beispiel in Zwei-Meter-Abständen anzuordnen. Denkbar ist auch, diese jeweils auf jedem Stockwerk anzubringen. Über diese Steckdosen 150 sind die einzelnen Leitungen in einem Messband 151 jeweils kontaktierbar, da jeder weibliche Verbindungsanschluss 152 bereits mit einer entsprechenden Leitung im Messband 151 vorkontaktiert ist. Zur Kontaktierung ist dann noch ein Stecker 153 notwendig, der an der entsprechenden Stelle eingesteckt werden kann. Die Steckdosen 150 können gegebenenfalls eine Abdeckung besitzen, die abnehmbar oder aufklappbar ist, falls diese nicht benötigt werden und somit vor Verschmutzung geschützt werden sollen. Derartige Steckdosen 150 besitzen aber auch den Vorteil, dass sie für Stabilität des Bandes insbesondere gegen Torsionen entlang der Längsachse schützen können. Die Steckdose 150 kann so ausgebildet sein, dass sie beispielweise von einem optischen Kamerasystem der Fahrkabine erfasst werden kann, beispielsweise, indem sie selbst entsprechende Markierungseinheiten aufweist. Zusätzlich können auch andere optische Indikatoren, wie beispielsweise Leuchtdioden (LED) vorhanden sein, welche anzeigen, ob ein Anschlussstecker 153 in einer der entsprechenden Steckdosen 150 eingesteckt ist.

Jeder Steckdose 150 kann eine eigene Adresse zugeordnet werden. Die Steckdose kann auf dem Messband geklemmt, geklebt, festgelötet, geschraubt, geclipt oder in sonstiger Weise verbunden sein.

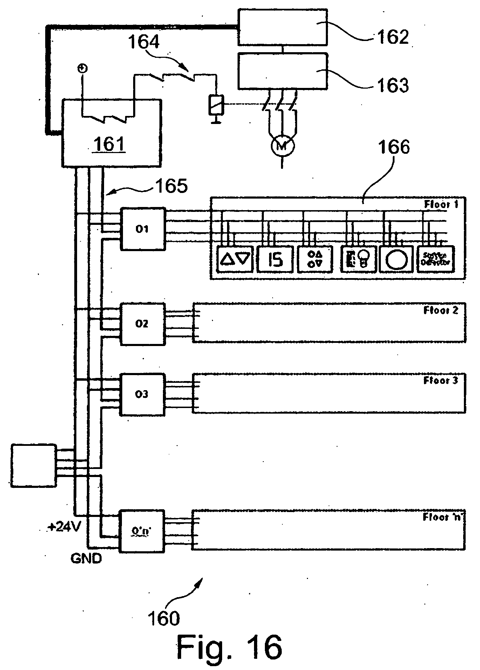

Figur 16 zeigt beispielsweise eine entsprechende Sicherheitsvorrichtung 160, welche einen Sicherheitscontroller 161 aufweist, der mit der Aufzugsteuerung 162 verbunden ist und somit unmittelbar den Antrieb des Aufzugs 163 kontrollieren kann. Insbesondere kann der Sicherheitscontroller 161 über einen Notschalter 164 den Antrieb des Aufzugs unmittelbar abschalten. Jedem Stockwerk ist ein optischer Schalter 01, 02, 03, On vorgesehen, der beispielsweise über eine Busleitung mit weiteren Komponenten verbunden sein kann, beispielsweise mit einer Positionsangabe oder mit Bedienschaltern des Aufzugs. Der optische Schalter 01, 02, 03, On zeigt jeweils an, ob zum Beispiel eine Schachttür geöffnet oder geschlossen ist. Diese entsprechenden Busleitungen, aber auch Stromleitungen und Erdungsleitungen 165 können entsprechend über ein Messband gemäß der Erfindung über die gesamten Stockwerke geführt werden.

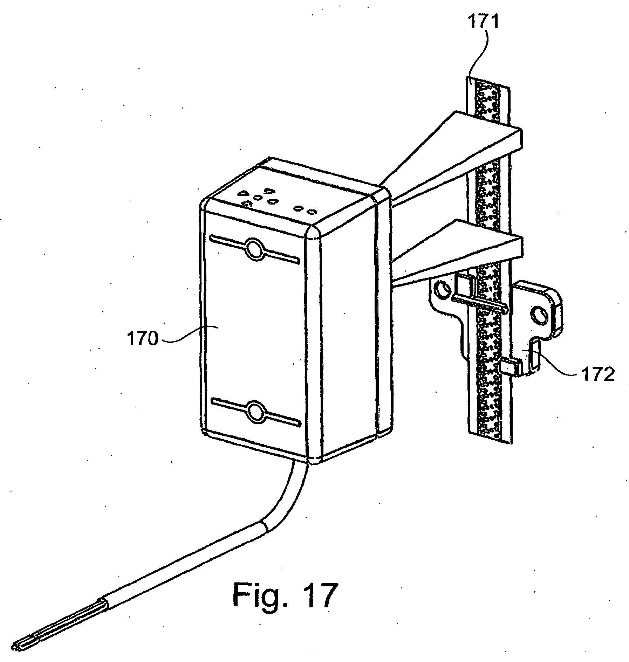

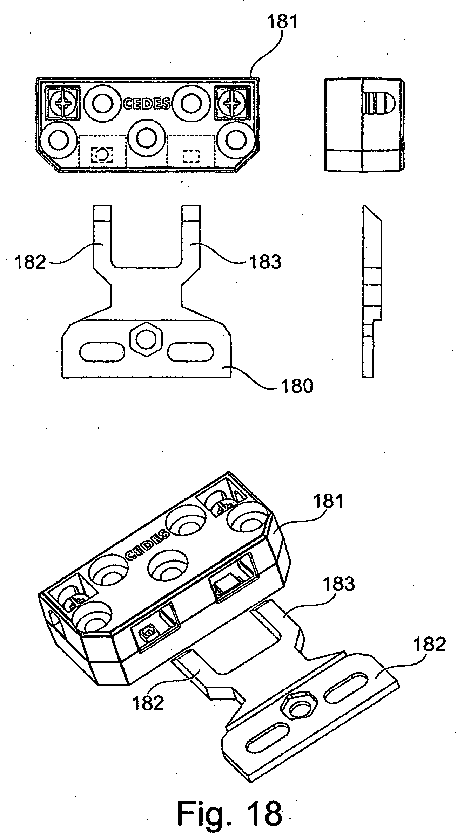

Figur 17 zeigt einen an einer Fahrkabine angeordneten Sensor 170, der eine Lichtquelle und einen optischen Empfänger umfasst, mit dem ein Messband 171, das eine Markierung trägt, ausgelesen werden kann. Des Weiteren sichtbar ist eine Lagerung 172 zur beweglichen Lagerung des Messbandes 171. Die in Figur 16 dargestellten optischen Schalter sind im Detail in Figur 18 noch einmal genauer dargestellt. Beim Schließen eines Kontaktes greift eine Kontaktbrücke 180 in den entsprechenden Schlitz eines Hauptkörpers 181 ein. Die beiden Schenkel 182 und 183 der optischen Brücke 180 stellen jeweils einen Lichtsender und einen Lichtempfänger dar, während im Hauptkörper 181 ein Lichtleiter angeordnet ist, sodass nur dann, wenn die Brücke 180 korrekt in die Vorrichtung 181 eingreift, eine optische Leitung von 182 nach 183 stattfinden kann. Nur unter dieser Bedingung ist der Schalter "geschlossen", was beispielsweise bedeutet, dass sicher festgestellt werden kann, dass eine Tür an einem Aufzug tatsächlich geschlossen ist.

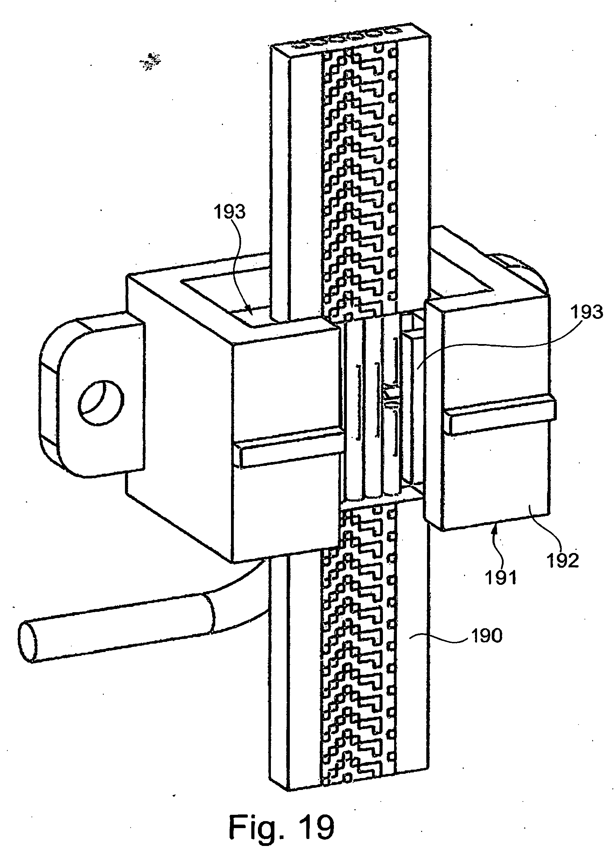

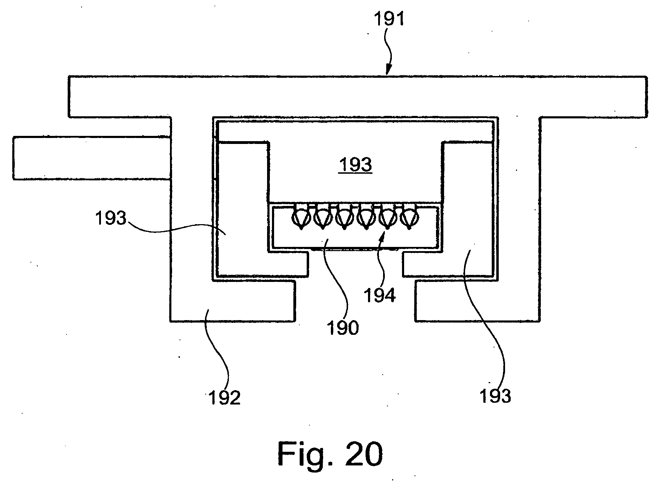

Figur 19 zeigt ein Messband 190 mit einer Verbindungsvorrichtung 191 mit einer beweglich in einer Halterung 192 gelagerten Kontaktierungsvorrichtung 193, durch welche die Leitungen im Messband (fest) kontaktiert werden können (über Schneidkontakte 194), wobei Gebäudeveränderungen, bedingt durch das Sich-Setzen des Gebäudes mit der Zeit aufgefangen werden können: Das Messband 190 bewegt sich relativ zur Schachtwand und nimmt dabei die Kontaktierungsvorrichtung 193 mit, bewegt sich also relativ zur Schachtwand und somit zur Halterung 192. Figur 20' zeigt eine Draufsicht auf die Vorrichtung gemäß Figur 19.

Bei weiteren Ausführungsformen ist es denkbar, dass die Verbindungsvorrichtung über der Markierung liegen kann und diese verdeckt, nämlich dann, wenn die Verbindungsvorrichtung selbst als Markierungseinheit vorgesehen ist und Informationen enthält, die beispielsweise an ihrer Außenseite angebracht sind. Dabei kann es sich insbesondere um Positionsangaben handeln. Zur Informationsübertragung und Kommunikation sind verschiedene Übertragungsmöglichkeiten denkbar. Insbesondere können auch verschiedene Bussysteme eingesetzt werden. Es ist sowohl ein unidirektionaler als ein bidirektionaler Kommunikationsbus denkbar.

Denkbar ist auch, Drähte mit geringem ohmschem Widerstand entlang des Messbands anzuordnen, indem entweder sehr gut leitende Metalle verwendet werden, oder aber, indem Drähte mit großem Querschnitt verwendet werden. Insbesondere dann, wenn die Drähte zur Stromversorgung dienen, kann diese Maßnahme von Vorteil sein, weil die Drähte dann einen geringeren Eigenwiderstand besitzen und die Verluste geringer sind.

Die Anzahl der Leitungen kann unterschiedlich gewählt werden, etwa 2, 5 oder sogar mehr. Zwei Leitungen können zur Stromversorgung verwendet werden und Abgriffe einer Spannungsquelle darstellen, mindestens ein Leiter kann als Erdung vorgesehen sein, zwei weitere Kabel können zur Kommunikation dienen. Wenigstens einer der Drähte kann in vorteilhafter Weise mit einer Sicherheitsvorrichtung verbunden werden. Als Bussystem kann ein CAN-Bus oder ein RS-485-Bus verwendet werden. Zu Kommunikationen können auch die Hauptstromleitungen verwendet werden, wenn die Signale aufmoduliert werden. Als Modellierung kann AM, FM, ASK, FSK, PSK, QPSK, QQPSK, M-PSK, pi/4-PSK, MSK, GMSK oder andere Modulationsmethoden verwendet werden. Die Kommunikation kann grundsätzlich auf analogen oder digitalen Wegen erfolgen.

Die zur Abschirmung verflochtenen Leitungspaare können zum Beispiel eine 100-Ohm-Impedanz aufweisen.

### Besonders bevorzugte Ausführungsformen von Messbändern:

Bei einer besonders bevorzugten Ausführungsform ist eine erste Schicht vorhanden, welche die Oberfläche vor Verschmutzungen, Kratzern oder sonstigen mechanischen Einwirkungen schützt und einen aufgedruckten Code zur Positionsbestimmung umfasst. Dahinter befindet sich eine für Infrarot transparente Schicht, die insgesamt wie ein Reflektor wirkt (indem die entsprechende Oberfläche auf der ihnen zugewandten Seite eine reflektierende Grenzflächenschicht besitzt). Das gesamte Messband bzw. Codetape besitzt ein Trägerband, das aus Metall oder einem verstärkten Material besteht, um mechanische Stabilität zu gewährleisten. Der Verstärkungsgrad und die Art der Verstärkung hängen von der Länge des Messbands ab. Die Leitungen sind als Kabel ausgebildet und paarweise miteinander verflochten, sodass auf diese Weise eine Abschirmung erreicht werden kann. Zusätzlich sind metallische oder in sonstiger Weise leitende Ummantelungen vorgesehen. Schichten, die zur mechanischen Verstärkung dienen, können auch zur Abschirmung oder beispielsweise als Träger für den aufgedrückten Positionscode oder als Reflektorschichten dienen. Die unterschiedlichen Schichten werden aufeinander laminiert oder zusammengeklebt.

Insgesamt werden bei der bevorzugten Ausführungsform der Erfindung fünf Leitungen verwendet: zwei zur Stromversorgung, zwei zur Kommunikation (nicht für eine Sicherheitsvorrichtung, sondern für die sonstige Kommunikation) und eine Busleitung. Die Busleitung wird von der Sicherheitsvorrichtung zusammen mit der Erdleitung benutzt. Durch eine weitere zusätzliche Erdungsleitung kann noch einmal mehr Stabilität erreicht werden. Es ist auch denkbar, bei einer solchen Ausführungsform statt Drähten Leiterbahnen, die aufgedruckt werden können, zu verwenden. Diese Leiterbahnen sind sodann nicht miteinander verflochten, aber mäanderartig übereinander angeordnet, sodass eine Abschirmungswirkung erreicht werden kann.

Die Verbindung zu den einzelnen Leitungen wird jeweils über Goldkontakte hergestellt, welche zum Beispiel gecrimpt werden, und zwar durch die Isolierung hindurch. Die Verflechtung der Drahtpaare erfolgt so, dass sie periodisch etwa alle zwei Meter das gleiche Muster ergibt, sodass die Verbindungen mit bestimmter Sicherheit regelmäßig übereinstimmen an entsprechenden Stellen. Die Verbindungsdosen werden an das Messband geklemmt und werden mit dem Sicherheitssystem und weiteren Hilfsvorrichtungen verbunden.

Das Messband wird nur an einer Stelle geerdet. Am anderen Ende des Messbands befindet sich ein Entstörkondensator, damit das Messband nicht als Antenne wirkt. Der Sicherheitsbus läuft über eine Analogleitung, wobei Strom- und Spannungsmodulation erfolgt. Alle anderen Geräte und Hilfsgeräte werden über die beiden zur sonstigen Kommunikation vorgesehenen Leitungen durchgeführt.

### Bezugszeichenliste:

- A: Aufzugvorrichtung
- S: Aufzugschacht
- K: Fahrkabine
- M1: Markierung
- M2: Markierung
- M3: Markierung
- Mn: Markierung
- V1: Verbindungsvorrichtungen
- V2: Verbindungsvorrichtungen
- Vn: Verbindungsvorrichtungen
- 1: Messband
- 2: obere Aufhängung
- 3: Markierungsseite
- 4: Leitungsseite
- 5: Kommunikationsleitungen
- 6: Datenleitungen
- 7: Elektronikeinheit
- 8: optische Sensor
- 10: Messband
- 11: Trägerband
- 12: Seitenbereich
- 13: Markierungsstreifen
- 14: Leitungen
- 15: Ausschnitt des Innenbereichs
- 20: Messband
- 21: Träger
- 22: Reflektor
- 23: Kunststoffschicht
- 24: Luftspalt
- 25: Codedruck
- 26: Befestigung
- 27: Isolator
- 28: Kupfer- oder Aluminiumleitung
- 29: Isolator
- 30: Leiterbahn
- 31: Isolatorschicht
- 40: Messband
- 41: Leitung
- 42: Metallkäfig
- 43: Markierung
- 44: Leitung
- 45: galvanische Trennung
- 46: Erdungskabel
- 47: Entstörkondensator
- C1: Clip
- C2: Clip
- Cn: Clip
- 50: Messband
- 51: Leitung
- 52: Metallkäfig
- 53: Markierung
- 54: Leitung
- 55: galvanische Trennung
- 56: Erdungskabel
- 57: Erdun,gskabel
- 58a: Erdungskabel
- 58b: Erdungskabel
- 58n: Erdungskabel
- 61: Leiterpaar
- 62: Leiterpaar
- 63: Leiterpaar
- 64: Erdungskabel
- 65: Erdungskabel
- 66: Erdungskabel
- 67: Erdungskabel
- 68: geerdete Abdeckung
- 69: Aussparung
- 71: Leitungspaare
- 72: Leitungspaare
- 73: Leitungspaare
- 74: Erdungskabel
- 75: Erdungskabel
- 76: Erdungskabel
- 77: Erdungskabel
- 78: Abschirmung
- 79: Aussparung
- 81: Leiterbahnpaar
- 82: Leiterbahnpaar
- 83: Leiterbahnpaar
- 84: Kontakt
- 85: Abschirmung
- 90: Verbindungsvorrichtung
- 91: Klammer
- 92: Verbindungselektrode/Schneidkontakt
- 93: Ausnehmung
- 94: Kabel
- 95a: Schneidkontakt
- 95b: Schneidkontakt
- 95c: isolierendes Unterbrechungsmesser
- 100: Leitung
- 101: Isolierung
- 102: Leitungsdraht
- 103: Kabel
- 104: Crimpvorrichtung
- 110: Messband
- 111: Leiterbahn
- 112: Abnehmerfinger
- 120: Kabel
- 121: Isolierung
- 122: Draht
- 123: Kondensatorplatte
- 130: Kabel
- 131: Kabel
- 140: Kabel
- 141: Kabel
- 150: Steckdose
- 151: Messband
- 152: Kontaktierungsbuchse
- 153: Stecker
- 160: Sicherheitssystem
- 161: Sicherheitskontroller
- 161: Aufzugsteuerung
- 163: Antrieb
- 164: Direktabschaltung
- 165: Leitungen
- 01: optische Schalter
- 02: optische Schalter
- 03: optische Schalter
- On: optische Schalter
- 166: Hilfsgeräte
- 170: optischer Sensor
- 171: Messband
- 172: Lagerung
- 180: optische Brücke
- 181: Hauptkörper
- 182: Schenkel
- 183: Schenkel
- 190: Messband / Codeband
- 191: Verbindungsvorrichtung
- 192: Halterung
- 193: beweglich gelagerte Kontaktierung
- 194: Schneidkontakte

## Patentansprüche

1. Verbindungsvorrichtung (v1, v2, vn, 90, 191) zur Verbindung einer Übertragungsvorrichtung zur Übertragung von Informationen, wobei die Übertragungsvorrichtung an einem Messband (1, 10, 40, 50, 110, 151, 171, 190) zur Bestimmung der Position einer Fahrkabine (K) in einem Aufzugschacht (S) angebracht ist, wobei das Messband vertikal im Aufzugschacht (S) angeordnet und in Bezug auf seine Länge so ausgebildet ist, dass es sich wenigstens Über zwei Stockwerke erstreckt, und wobei das Messband (1, 10, 40, 50, 110, 151, 171, 190) eine Markierungseinheit (M1, M2, M3, Mn, 13, 25, 43, 53) zur Markierung von wenigstens zwei Positionen im Aufzugschacht (S) umfasst, wobei die Markierungseinheit (M1, M2, M3, Mn; 13, 25, 43, 53) entlang der Länge des Messbandes (1, 10, 40, 50, 110, 151, 171, 190) verläuft, und wobei das Messband (1, 10, 40, 50, 110, 151, 171, 190) ein Trägerband (11, 21) umfasst, wobei die Übertragungsvorrichtung wenigstens eine Kommunikationsleitung (5, 14, 28, 30, 41, 51, 61, 62, 63, 71, 72, 73, 81, 82, 83, 111, 122, 130, 140) zur Übermittlung eines Informationasignals und/oder wenigstens eine Versorgungsleitung (14, 28, 30, 41, 51, 61, 62, 63, 71, 72, 73, 81, 82, 83, 111, 122, 130, 140) zur Stromversorgung umfasst und die wenigstens eine Kommunikationsleitung entlang der Länge des Messbands verläuft, wobei die Kommunikationsleitung als elektrische Leitung zur Übermittlung eines elektrischen Signals oder als Glasfaserleitung zur Übermittlung eines optischen Signals ausgebildet ist, wobei die Verbindungsvorrichtung (V1, V2, Vn, 90, 191) als Führungsklammer zur Führung und/oder Lagerung des Messbands ausgebildet ist, sodass sie das Messband wenigstens teilweise umgibt, und wobei die Führungsklammer wenigstens eine Aussparung (79, 93) zum Auslesen der Markierungseinheit (M1, M2, M3, Mn, 13, 25, 43, 53) aufweist und wobei die Verbindungsvorrichtung wenigstens einen Verbindungskontakt zur Verbindung mit einer der Kommunikationsleitungen und/oder Versorgungsleitungen aufweist, **dadurch gekennzeichnet, dass** der wenigstens eine Verbindungskontakt (193) beweglich in der Verbindungsvorrichtung gelagert ist, um Relativbewegungen ausgleichen zu können.

2. Verbindungsvorrichtung (V1, V2, Vn, 90, 191) nach Anspruch 1, **dadurch gekennzeichnet, dass** die Verbindungsvorrichtung zum drahtgebundenen elektrischen Kontaktieren ausgebildet ist, insbesondere ein Schneidkontakt (95a, 95b, 95c, 194) zum schneidenden Kontaktieren wenigstens einer der Kontaktleitungen durch Verletzen der Isolierung der Kontaktleitung oder eine Crimpvorrichtung (64, 74, 104) zur Herstellung einer Crimpverbindung zu wenigstens einer der Kontaktleitungen umfasst.

3. Verbindungsvorrichtung (V1, V2, Vn, 90, 191) nach einem der vorgenannten Ansprüche, **dadurch gekennzeichnet, dass** die Verbindungsvorrichtung wenigstens einen federgespannter Kontaktpin (112) zum drahtgebundenen elektrischen Kontaktieren, insbesondere zum Kontaktieren einer als Leiterbahn ausgebildeten Kontaktleitung umfasst.

4. Verbindungsvorrichtung (V1, V2, Vn, 90, 191) nach einem der vorgenannten Ansprüche, **dadurch gekennzeichnet, dass** die Verbindungsvorrichtung dazu ausgebildet ist, eine drahtlose Verbindung (61, 62, 71, 72, 123, 131, 141) zu wenigstens einer der Kontaktleitungen herzustellen, insbesondere eine induktive oder kapazitive Verbindung.

5. Verbindungsvorrichtung (V1, V2, Vn, 90, 191) nach einem der vorgenannten Ansprüche, **dadurch gekennzeichnet, dass** die Verbindungsvorrichtung als Verbindungsstecker (153) und/oder als männliche Steckverbindung ausgebildet ist.

6. Verbindungsvorrichtung (V1, V2, Vn, 90, 191) nach einem der vorgenannten Ansprüche, **dadurch gekennzeichnet, dass** eine Verbindungstestvorrichtung zum Testen der Verbindung zu wenigstens einer der Kontaktleitungen an einer bestimmten Stelle vorgesehen ist.

7. Peripheriegerät für Aufzugvorrichtungen (A), insbesondere Positionsbestimmungsvorrichtung oder Sicherungsvorrichtung (160) oder Kommunikationsvorrichtung mit Verbindungsvorrichtung (V1, V2, Vn, 90, 191) nach einem der vorgenannten Ansprüche.

8. Peripheriegerät nach Anspruch 7, **dadurch gekennzeichnet, dass** eine Testvorrichtung zum Testen des Messbandes (1, 10, 40, 50, 110, 151, 171, 190) auf Brüche und/oder auf Ausdehnungen des Messbandes hin Vorhanden ist, indem eine Laufzeitmessung eines Signals durch wenigstens eine der Kontaktleitungen (5, 14, 28, 30, 41, 51, 61, 62, 63, 71, 72, 73, 81, 82, 83, 111, 122, 130, 140) und/oder ein Kapazitätsmessung wenigstens einer der Kontaktleitungen und/oder eine Durchgangsprüfung wenigstens einer der Kontaktleitungen durchgeführt wird und/oder eine Verbindungstestvorrichtung zum Testen der Verbindung zu wenigstens einer der Kontaktleitungen an einer bestimmten Stelle vorgesehen ist.

9. Aufzugvorrichtung (A), **dadurch gekennzeichnet, dass** ein Peripheriegerät (160) nach einem der Ansprüche 7 oder 8 vorgesehen ist.

## Claims

1. Connecting device (V1, V2, Vn, 90, 191) for connecting a transmission device for transmitting information, wherein the transmission device is attached to a measurement tape (1, 10, 40, 50, 110, 151, 171, 190) for determining the position of a cab (K) in an lift shaft (S), the measurement tape being situated vertically in the lift shaft (S) and being designed with respect to its length in such a way that it extends over at least two floors, and wherein the measurement tape (1, 10, 40, 50, 110, 151, 171, 190) comprises a marking unit (M1, M2, M3, Mn, 13, 25, 43, 53) for marking at least two positions in the lift shaft (S), wherein the marking unit (M1, M2, M3, Mn, 13, 25, 43, 53) runs along the length of the measurement tape (1, 10, 40, 50, 110, 151, 171, 190), and wherein the measurement tape (1, 10, 40, 50, 110, 151, 171, 190) comprises a carrier tape (11, 21), wherein the transmission device includes at least one communication line (5, 14, 28, 30, 41, 51, 61, 62, 63, 71, 72, 73, 81, 82, 83, 111, 122, 130, 140) for transmitting an information signal and/or at least one supply line (14, 28, 30, 41, 51, 61, 62, 63, 71, 72, 73, 81, 82, 83, 111, 122, 130, 140) for supplying power, and the at least one communication line runs along the length of the measurement tape, wherein the communication line is designed as an electrical line for transmitting an electrical signal or as a fiberglass line for transmitting an optical signal, wherein the connecting device (V1, V2, Vn, 90, 191) is designed as a guide bracket for guiding and/or supporting the measurement tape, so that it at least partially surrounds the measurement tape, and wherein the guide bracket has at least one opening (79, 93) for reading out the marking unit (M1, M2, M3, Mn, 13, 25, 43, 53), and wherein the connecting device has at least one connection contact for connecting to one of the communication lines and/or supply lines, **characterised in that** the at least one connection contact (193) is movably supported in the connecting device in order to compensate for relative move-ments.

2. Connecting device (V1, V2, Vn, 90, 191) according to claim 1, **characterised in that** the connecting device is designed for wired electrical contacting, in particular a displacement contact (95a, 95b, 95c, 194) for displacement contacting at least one of the contact lines by breaching the insulation of the contact line or a crimping device (64, 74, 104) for producing a crimp connection to at least one of the contact lines.

3. Connecting device (V1, V2, Vn, 90, 191) according to any one of the preceding claims, **characterised in that** the connecting device comprises at least one spring-loaded contact pin (112) for wired electrical contact, in particular for contacting a contact line designed as a conducting path.

4. Connecting device (V1, V2, Vn, 90, 191) according to any one of the preceding claims, **characterised in that** the connecting device is designed to establish a wireless connection (61, 62, 71, 72, 123, 131, 141) to at least one of the contact lines, in particular an inductive or capacitive connection.

5. Connecting device (V1, V2, Vn, 90, 191) according to any one of the preceding claims, **characterised in that** the connecting device is designed as a connecting plug (153) and/or as a male plug connection.

6. Connecting device (V1, V2, Vn, 90, 191) according to any one of the preceding claims, **characterised in that** a connection test device is provided for testing the connection to at least one of the contact lines at a certain point.

7. Peripheral device for lift devices (A), in particular a position determining device or safety device (160) or communication device with a connecting device (V1, V2, Vn, 90, 191) according to any of the preceding claims.

8. Peripheral device according to claim 7, **characterised in that** a testing device is provided for testing the measure-ment tape (1, 10, 40, 50, 110, 151, 171, 190) for breaks and/or stretches in the measurement tape, by carrying out a runtime measurement of a signal through at least one of the contact lines (5, 14, 28, 30, 41, 51, 61, 62, 63, 71, 72, 73, 81, 82, 83, 111, 122, 130, 140) and/or a capacity measurement of at least one of the contact lines and/or a throughput check of at least one of the contact lines and/or a connection test device is provided for testing the connection to at least one of the contact lines at a specific point.

9. Lift device (A), **characterised in that** a peripheral device (160) is provided according to either claim 7 or claim 8.

## Revendications

1. Dispositif de connexion (V1, V2, Vn, 90, 191) pour connecter un dispositif de transmission servant à transmettre des informations, le dispositif de transmission étant monté sur un ruban de mesure (1, 10, 40, 50, 110, 151, 171, 190) destiné à la détermination de la position d'une cabine d'ascenseur (K) dans une cage d'ascenseur (S), le ruban de mesure étant disposé verticalement dans la cage d'ascenseur (S) et étant conçu, du point de vue de sa longueur, de manière à s'étendre sur au moins deux étages, et le ruban de mesure (1, 10, 40, 50, 110, 151, 171, 190) comprenant une unité de marquage (M1, M2, M3, Mn, 13, 25, 43, 53) destinée au marquage d'au moins deux positions dans la cage d'ascenseur (S), l'unité de marquage (M1, M2, M3, Mn, 13, 25, 43, 53) s'étendant le long de la longueur du ruban de mesure (1, 10, 40, 50, 110, 151, 171, 190), et le ruban de mesure (1, 10, 40, 50, 110, 151, 171, 190) comprenant une bande support (11, 21), le dispositif de transmission comprenant au moins une ligne de communication (5, 14, 28, 30, 41, 51, 61, 62, 63, 71, 72, 73, 81, 82, 83, 111, 122, 130, 140) destinée à la transmission d'un signal d'information et/ou au moins une ligne d'alimentation (14, 28, 30, 41, 51, 61, 62, 63, 71, 72, 73, 81, 82, 83, 111, 122, 130, 140) destinée à l'alimentation en courant, et la ou les lignes de communication s'étendant le long de la longueur du ruban de mesure, la ligne de communication étant réalisée sous la forme d'une ligne électrique destinée à la transmission d'un signal électrique ou sous la forme d'une ligne en fibres de verre destinée à la transmission d'un signal optique, le dispositif de connexion (V1, V2, Vn, 90, 191) étant réalisé sous la forme d'une bride de guidage destinée au guidage et/ou au montage du ruban de mesure, de sorte qu'il entoure au moins en partie le ruban de mesure, et la bride de guidage comprenant au moins un évidement (79, 93) destiné à la lecture de l'unité de marquage (M1, M2, M3, Mn, 13, 25, 43, 53), le dispositif de connexion comprenant au moins un contacts de connexion destiné à la connexion avec l'une des lignes de communication et/ou des lignes d'alimentation, **caractérisé en ce que** le au moins un contact de connexion (193) est logé mobile dans le dispositif de connexion pour permettre de compenser des déplacements relatifs.

2. Dispositif de connexion (V1, V2, Vn, 90, 191) selon la revendication 1, **caractérisé en ce que** le dispositif de connexion est conçu pour une mise en contact électrique filaire, et comprend en particulier un contact autodénudant (95a, 95b, 95c, 194) pour le contact par dénudage d'au moins une des lignes de contact par endommagement de l'isolant de la ligne de contact ou un dispositif de sertissage destiné à établir une connexion sertie (64, 74, 104) avec au moins une des lignes de contact.

3. Dispositif de connexion (V1, V2, Vn, 90, 191) selon l'une des revendications précédentes, **caractérisé en ce que** le dispositif de connexion comprend au moins une broche de contact (112) sollicitée par un ressort permettant la mise en contact électrique filaire, en particulier pour la mise en contact électrique d'une ligne de contact réalisée sous la forme d'une piste conductrice.

4. Dispositif de connexion (V1, V2, Vn, 90, 191) selon l'une des revendications précédentes, **caractérisé en ce que** le dispositif de connexion est conçu pour établir une connexion sans fil (61, 62, 71, 72, 123, 131, 141) avec au moins une des lignes de contact, en particulier une connexion inductive ou capacitive.

5. Dispositif de connexion (V1, V2, Vn, 90, 191) selon l'une des revendications précédentes, **caractérisé en ce que** le dispositif de connexion est conçu sous la forme d'une fiche de connexion (153) et/ou sous la forme d'une fiche de raccordement mâle.

6. Dispositif de connexion (V1, V2, Vn, 90, 191) selon l'une des revendications précédentes, **caractérisé en ce qu**'un dispositif de contrôle de connexion est prévu pour contrôler la connexion avec au moins une des lignes de contact en un point défini.

7. Appareil périphérique pour dispositifs d'ascenseur (A), en particulier dispositif de détermination de position ou dispositif de sécurité (160) ou dispositif de communication comprenant un dispositif de connexion (V1, V2, Vn, 90, 191) selon l'une des revendications précédentes.

8. Appareil périphérique selon la revendication 7, **caractérisé en ce qu**'un dispositif de contrôle destiné à contrôler le ruban de mesure (1, 10, 40, 50, 110, 151, 171, 190) est présent pour rechercher des ruptures et/ou des distensions du ruban de mesure en effectuant une mesure du temps de propagation d'un signal à travers au moins une des lignes de contact (5, 14, 28, 30, 41, 51, 61, 62, 63, 71, 72, 73, 81, 82, 83, 111, 122, 130, 140) et/ou une mesure de capacité d'au moins une des lignes de contact et/ou un contrôle de continuité d'au moins une des lignes de contact et/ou un dispositif de contrôle de connexion est prévu pour contrôler la connexion avec au moins une des lignes de contact en un point défini.

9. Dispositif d'ascenseur (A), **caractérisé en ce qu**'il est prévu un appareil périphérique (160) selon l'une des revendications 7 ou 8.
